**Europäisches Patentamt**

**European Patent Office**

**Office européen des brevets**

(19)

(11) Veröffentlichungsnummer: **0 071 265**
**B1**

# (12) EUROPÄISCHE PATENTSCHRIFT

(45) Veröffentlichungstag der Patentschrift:
**23.04.86**

(21) Anmeldenummer: **82106842.6**

(22) Anmeldetag: **28.07.82**

(51) Int. Cl.⁴: **G 01 R 19/165, H 03 K 5/24**

(54) **Monolithisch integrierbare MOS-Komparatorschaltung.**

(30) Priorität: **31.07.81 DE 3130391**

(43) Veröffentlichungstag der Anmeldung:
**09.02.83 Patentblatt 83/6**

(45) Bekanntmachung des Hinweises auf die Patenterteilung:
**23.04.86 Patentblatt 86/17**

(84) Benannte Vertragsstaaten:
**AT DE FR GB**

(56) Entgegenhaltungen:
**US - A - 4 045 686**
**US - A - 4 197 472**

**Patent Abstract of Japan, vol. 5, no. 17, 31 January 1981**

(73) Patentinhaber: **Siemens Aktiengesellschaft, Berlin und München Wittelsbacherplatz 2, D-8000 München 2 (DE)**

(72) Erfinder: **Reiner, Robert, Dipl.-Ing., P.O. Box 15888, Lynn East 0039 (ZA)**

**Beschreibung**

Die Erfindung betrifft eine monolithisch integrierbare MOS-Komparatorschaltung nach dem Oberbegriff des Patentanspruchs 1.

Komparatorschaltungen dieser Art sind an sich üblich und können auf verschiedene Weise ausgestaltet sein. Eine Möglichkeit besteht in der Kombination der beiden – jeweils als ein Inverter ausgestalteten-Verstärkerstufen zu einem Flip-Flop, das an der einen Seite z.B. durch den Speicherinhalt einer adressierten binären Speicherzelle und an der anderen Seite durch den Speicherinhalt einer in der gleichen Weise wie die Speicherzelle ausgestalteten und dimensionierten Referenzzelle beaufschlagt wird. Eine andere Möglichkeit besteht darin, einen als Differenzverstärker ausgebildeten Komparator zu verwenden, dessen beide Zweige durch MOS-Transistoren gegeben sind.

Für den Einsatz in schnellen Analog-Digital-Wandlern sind jedoch derartig ausgebildete Komparatoren weniger geeignet.

Schnelle Analog-Digital-Wandler können bekanntlich aus parallel arbeitenden Spannungskomparatoren aufgebaut werden. Dabei benötigt man bei einem in reinem Parallelbetrieb arbeitenden Analog-Digitalwandler mit n Bit Auflösung insgesamt $(2^n - 1)$ solcher Komparatoren. Bei einer monolithischen Realisierung zieht dies den Nachteil eines beträchtlichen Flächenbedarfs in dem die Schaltung aufnehmenden Halbleiterplättchen nach sich, sofern man sich nicht mit einer kleinen Bit-Zahl für den A/D-Wandler zufrieden geben will. Ausserdem führen die bekannten Komparatorzellen zu einem erheblichen Strombedarf. Es wäre deshalb wünschenswert, die einzelnen Komparatorzellen so auszugestalten, dass sie einen sehr geringen Flächenbedarf haben und nur wenig Strom benötigen.

Weiter kommt es darauf an, die Schwankungen der Bewertungsschwelle von einem Komparator zum anderen Komparator kleiner als die geforderte Auflösung zu machen. Diese Schwankungen sind bei einer Realisierung in MOS-Technik wegen der Relativschwankung der Schwellenspannung von MOS-Transistoren in der Grössenordnung von 50 mV. Bei einem Hub der Messspannung von 3 V würde dadurch die Auflösung auf ca. 5 Bit begrenzt sein. Häufig werden jedoch 7 oder gar 8 Bit an Auflösung gefordert.

Schliesslich ist festzustellen, dass der Hub der Messspannung von 3 V, wie er in solchen und auch in anderen Fällen erforderlich ist, gross im Vergleich zu den für integrierte Schaltungen aus bekannten Gründen anzuwendenden Versorgungsspannungen von 3,5–5 V ist. Der Komparator sollte in diesem grossen Bereich für die Signaleingangsspannung ausreichend rasch und empfindlich sein, um das Eingangssignal mit dem Referenzsignal vergleichen zu können.

Bekannte Lösungen der zuletzt genannten Probleme sind auf die Anwendung von aus komplementären MOS-Transistoren aufgebauten Invertern basiert. Aus der US-A 4 197 472 ist ein Spannungskomparator für einen Analog/Digital-Wandler bekannt, welcher eine Vielzahl von hintereinander geschalteten als Inverter ausgebildeten Verstärkerstufen aufweist. Die zu vergleichenden Eingangsspannungen und Referenzspannungen werden über je einen taktgesteuerten Transistor wechselweise an denselben Pol eines Kondensators gelegt, dessen zweiter Pol unmittelbar mit dem Steuereingang des ersten Inverters verbunden ist. Alle Verstärker sind parallel an eine Versorgungsspannung anschaltbar. Eine Realisierung in CMOS-Technik hat zwar auch den Vorteil der Energieersparnis, der aber mit dem Nachteil eines höheren Platzbedarfs auf dem Halbleiterplättchen und dem Nachteil eines erheblich grösseren Herstellungsaufwands verbunden ist. Es ist deshalb ein den genannten Wünschen Rechnung tragender Komparator anzustreben, der sich in Ein-Kanal-MOS-Technik, insbesondere in n-Kanal-Technik, realisieren lässt und dessen Platzbedarf nur gering ist. Die Erfindung befasst sich mit der Aufgabe, einen solchen Komparator anzugeben.

Diese Aufgabe wird gemäss dem kennzeichnenden Teil des Anspruchs 1 gelöst.

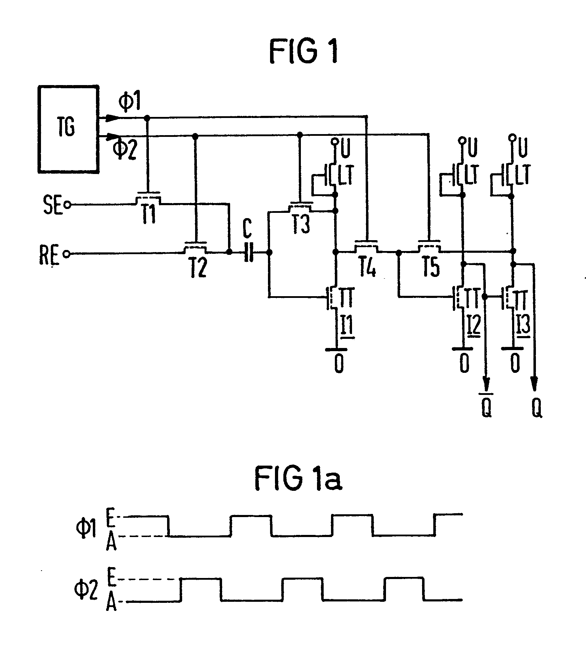

Dabei kann das eine Taktsignal mit dem den Referenzeingang an den besagten Kondensator schaltenden Taktsignal und das andere Taktsignal mit dem den Signaleingang an den Kondensator schaltenden Taktsignal identisch sein, wie dies bei der in Figur 1 dargestellten Schaltung des erfindungsgemässen Komparators der Fall ist. Es ist aber auch eine Vertauschung der Rollen der beiden die Eingangstransfertransistoren steuernden Taktfolgen bei der Steuerung der übrigen Transfertransistoren möglich.

Die Erfindung besteht – in anderen Worten ausgedrückt – darin, dass ein mehrstufiger, z.B. in n-Kanaltechnik ausgeführter MOS-Verstärker so umgeschaltet wird, dass in einer ersten Taktphase alle drei (durch je einen der Inverter gegebenen) Verstärkerstufen in Serie einen hohen Verstärkungsfaktor ergeben, und dass dann in einer zweiten Taktphase die beiden letzten Verstärkerstufen zu einem Flip-Flop zusammengeschaltet werden, das dann durch seine Rückkopplung das Signal soweit verstärkt, dass eine logische Entscheidung herbeigeführt wird und bis zum Ende dieser Taktphase auf den Ausgang als digitale Information wirksam ist.

Die zweite und die dritte Verstärkerstufe sind beide genau so dimensioniert wie die erste Verstärkerstufe, damit der Arbeitspunkt $U_{in} = U_{out} = U_o$ ($U_o$ = Arbeitspunktspannung) weitgehend für alle drei Verstärkerstufen gilt. Damit arbeitet die Kette aus den drei Verstärkerstufen, also den drei Invertern, im empfindlichen Bereich, wenn die Signalspannung etwa gleich der Referenzspannung ist. Während der Messphase, d.h., wenn die drei Verstärkerstufen in Serie geschaltet sind, stellt sich am Ausgang der Verstärkerkette, also am Ausgang des dritten Inverters, entsprechend der Differenz zwischen der Signalspannung und der Referenzspannung, die Ausgangsspannung ein. Während der anderen Taktphase, während der der die erste Verstärkerstufe darstellende erste Inverter gegengekoppelt ist, werden die beiden nachfolgenden Verstärkerstufen von der Vorstufe abgetrennt und über einen Transferschalter, der durch den an vierter Stelle in der Definition der Erfindung genannten Transfertransistor gegeben ist, zu einem Flip-Flop rückgekoppelt. Dieses Flip-Flop schwingt sehr schnell auf digitale Pegel ein und speichert die Information bis zur nächsten Messphase für die Signaleingangsspannung.

Ein wesentlicher Vorteil der erfindungsgemässen Anordnung besteht darin, dass die Zeit, in der die erste Inverterstufe gegengekoppelt ist, auch in der zweiten und dritten Inverterstufe genutzt wird, nämlich zur Nachverstärkung und Speicherung. Ein anderer Vorteil ist, dass durch die doppelte Nutzung der zweiten und dritten Inverterstufe an Fläche und Verlustleistung gespart wird.

Durch eine der Erfindung entsprechende Anordnung wird ausserdem die Zeit, in der am Signalausgang des aus dem zweiten und dem dritten Inverter temporär gebildeten Flip-Flops das Ausgangssignal zur Verfügung steht, zwar gekürzt. Jedoch ist dieses digitale Signal lediglich für die Übernahme des Signals in die durch den Komparator zu beaufschlagende Schaltung, z.B. einer Prioritätslogik und einem Dekoder, von Bedeutung, so dass die Verkürzung keine Nachteile mit sich bringt.

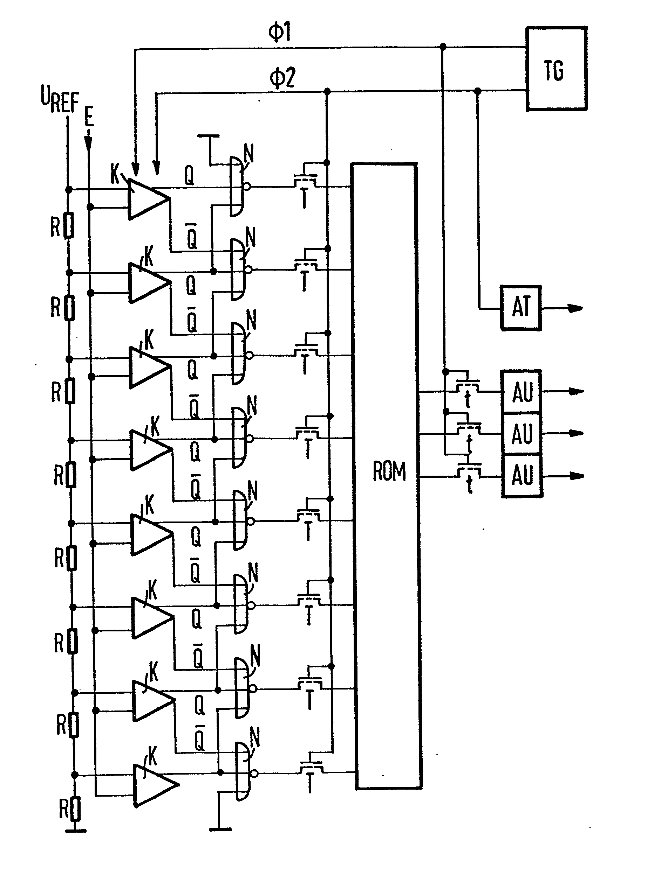

Die Erfindung wird nun anhand der Figuren 1 und 2 weiter vorgestellt. Dabei ist in Figur 1 das Schaltbild des erfindungsgemässen Komparators und in Figur 2 ein Blockschaltbild für den Einsatz des erfindungsgemässen Komparators in einer nach dem Parallelverfahren arbeitenden Schaltung für einen Analog-Digital-Wandler dargestellt. Figur 1a zeigt das Zeitdiagramm der für den Betrieb eines Komparators gemäss der Erfindung zu verwendenden Taktsignale $\emptyset_1$ und $\emptyset_2$. Sie können z.B. durch einen Taktgeber TG geliefert werden, wie er in der DE-A1 2 713 319 (VPA 77 P 1027) beschrieben ist.

Der Signaleingang SE des Komparators ist über einen ersten Transfertransistor T1 und der Referenzeingang RE über einen zweiten Transfertransistor T2 an denselben Pol eines Kondensators C gelegt, der z.B. als MOS-Kondensator realisiert sein kann. Dabei wird das Gate des ersten Transfertransistors T1 durch die Taktimpulsfolge $\emptyset_1$ und das Gate des zweiten Transfertransistors T2 durch die Impulsfolge $\emptyset_2$ gesteuert. Der Zeitverlauf dieser beiden von dem Taktgeber TG gelieferten Impulsfolgen $\emptyset_1$ und $\emptyset_2$ ist in Fig. 1a dargestellt.

Die Transfertransistoren T1, T2 sowie die übrigen Transfertransistoren T3 bis T6 sind vom selbstsperrenden Typ. Dasselbe gilt für die Treibertransistoren TT der Inverter I1, I2 und I3. Die Lasttransistoren LT in den Invertern in Fig. 1 sind selbstleitend. Es können aber auch selbstsperrende Lasttransistoren LT eingesetzt werden, wenn die Schaltung in entsprechender Weise abgeändert wird. Sämtliche Transistoren sind im Beispielsfall vom n-Kanaltyp, was im Interesse einer höheren Schaltgeschwindigkeit günstiger als die ebenfalls mögliche Verwendung von p-Kanal-MOS-FET's ist. Vorzugsweise sind die Treibertransistoren TT einerseits und die Lasttransistoren andererseits sowie auch die Transfertransistoren jeweils gleich dimensioniert, damit sich bei der Herstellung ein Minimum an Relativtoleranzen ergibt.

Der durch den Signaleingang SE bzw. den Referenzeingang RE beaufschlagte Kondensator C liegt, wie aus Fig. 1 ersichtlich ist, mit seinem anderen Pol unmittelbar am Eingang des die erste Verstärkerstufe I1 bildenden Inverters, der durch das Gate des zugehörigen Treibertransistors TT gegeben ist. Dieser liegt mit seinem Sourceanschluss am Bezugspotential 0 V und mit seinem Drain am Ausgang des Inverters I1 sowie über die Source-Drainstrecke des als Diode geschalteten Lasttransistors LT des Inverters I1 am ersten Versorgungspotential U.

Der Ausgang des ersten Inverters I1 führt über das vom Referenztakt $\emptyset_2$ gesteuerte dritte Transfergate T3 zurück zum Steuereingang des ersten Inverters I1, d.h. also an das Gate von dessen Treibertransistor TT. Der Signalausgang des ersten Inverters I1 ist ausserdem über den durch den Signaleingang SE an den Kondensator C legenden Signaltakt $\emptyset_1$ gesteuerten vierten Transfertransistor T4 an den Steuereingang des zweiten Inverters I2 und damit der zweiten Verstärkerstufe des erfindungsgemässen Komparators gelegt. Der Signalausgang des zweiten Inverters I2 liegt entsprechend der Definition der Erfindung am Steuereingang eines dritten Inverters I3 und damit am Gate des Treibertransistors TT dieses Inverters. Die drei Inverter I1, I2, I3 sind im Aufbau sowie bezüglich der Anschaltung an das Bezugspotential sowie an die Versorgungsspannung U einander völlig gleich.

Entsprechend der Definition der Erfindung ist ausserdem der Ausgang des dritten Inverters I3 mit dem Eingang des zweiten Inverters I2 über einen fünften Transfertransistor T5 verbunden. Der Ausgang des dritten Inverters I3 bildet den Q-Ausgang des bei entsprechender Schaltung der Transfertransistoren aus den Invertern I2 und I3 entstehenden RS-Flip-Flops, während der $\overline{Q}$-Ausgang dieses Flip-Flops mit dem Signalausgang des zweiten Inverters I2 identisch ist. Die beiden Ausgänge Q und $\overline{Q}$ sind die Signalausgänge des Komparators.

Bei Verwendung von selbstsperrenden MOS-Feldeffekttransistoren als Lasttransistoren LT kann man z.B. anstelle der aus Fig. 1 ersichtlichen Anschaltung für das Gate dieser Transistoren das Gate mit dem Drain, d.h. also mit dem Versorgungspotential U, verbinden.

Zur weiteren Erläuterung wird die Anwendung der beschriebenen Komparatorzelle anhand von Figur 2 beschrieben.

Bei dem Blockschaltbild eines im Parallelbetrieb arbeitenden Analog-Digital-Wandlers gemäss Fig. 2 ist eine der gewünschten Auflösung n entsprechende Anzahl von Komparatoren K gemäss Fig. 1 vorgesehen, deren Signaleingänge SE (in Fig. 2 nicht näher bezeichnet) an dem durch das auszuwertende Analogsignal beaufschlagten Signaleingang E des A/D-Wandlers liegen. Ein aus einer zwischen dem Versorgungspotential U und dem Bezugspotential liegende Kette aus n hintereinander geschalteten und einander gleichen Widerständen R bildet einen Spannungsteiler, dessen Teilerpunkte jeweils einem der Komparatoren K zugeordnet sind, indem je ein Teilerpunkt mit dem Referenzeingang RE (in Fig. 2 nicht näher bezeichnet) je eines der vorgesehenen Komparatoren K verbunden ist.

Jedem der Komparatoren K ist je ein NOR-Gatter N mit jeweils drei Signaleingängen zugeordnet, indem der nichtinvertierende Ausgang Q dieses Komparators K mit dem einen Signaleingang des zugehörigen NOR-Gatters N verbunden ist. Ausserdem liegt der $\overline{Q}$-Ausgang der einzelnen Komparatoren K an einem zweiten Signaleingang des NOR-Gatters N, das der jeweils um je ein Bit niedriger liegenden Bewerterstufe, d.h. deren Komparator K zugeordnet ist. Eine Ausnahme hierbei bildet das dem Komparator K der niedrigsten Bewerterstufe zugeordnete NOR-Gatter N, wie aus Fig. 2 ersichtlich ist. Schliesslich ist der Q-Ausgang der einzelnen Komparatoren K an einen weiteren Eingang des NOR-Gatters N angeschlossen, das der jeweiligen nächsthöheren Bewerterstufe zugeordnet ist. Eine aus Fig. 2 ersichtliche Ausnahme bildet hier das der höchsten Bewerterstufe zugeordnete NOR-Gatter. Die NOR-Gatter N dienen der Wandlung des Codes in die Form «1-aus n», d.h. im Falle der Fig. 2 in die Form «1-aus-8».

Der Ausgang der einzelnen NOR-Gatter N führt über je einen Transfertransistor T an je einen Eingang eines Code-Wandlers, der z.B. durch einen ROM-Speicher ROM gegeben ist. Dieser dient der Wandlung des Codes in einen Dual-Code. Für die Steuerung der Transfertransistoren T ist das Taktsignal $\emptyset_2$ vorgesehen, welches gemäss der Definition der Erfindung zur Steuerung des dritten und des fünften Transfertransistors, also der Transistoren T3 und T5 des in Figur 1 dargestellten Komparators dient. Es wird von dem Taktgeber TG, dessen Signale $\emptyset_1$ und $\emptyset_2$ zur gemeinsamen Steuerung der n Komparatoren K vorgesehen sind, geliefert.

Jeder Komparator K der in Fig. 2 dargestellten Schaltung vergleicht die am Signaleingang E liegende analoge Signalspannung mit der ihm aufgrund der Anschaltung an den Spannungsteiler jeweils zugeordneten Referenzspannung. Die Komparatoren K, für die die Signalspannung kleiner ist als die Referenzspannung (obere Gruppe) liefern an ihrem Ausgang Q eine logische «1» und der Rest der Komparatoren K (untere Gruppe) eine logische «0». Die interessierende Information liegt an der Stelle, an der der Übergang von der unteren Gruppe zur oberen Gruppe von Komparatoren K gegeben ist. Die NOR-Gatter N stellen die Stelle dieses Übergangs fest. Ersichtlich wird aufgrund der Schaltung gemäss Fig. 2 nur dasjenige NOR-Gatter N an seinem Ausgang den Zustand logisch «1» annehmen, dessen oberer Nachbarkomparator K (also der Komparator der nächst höheren Bewertungsstufe) an seinem invertierenden Ausgang $\overline{Q}$ das Signal logisch «0» liefert.

Das Signal am Q-Ausgang des jeweiligen unteren Nachbarkomparators (also der Komparator der nächst niedrigeren Bewertungsstufe) liegt an einem dritten Eingang des der betrachteten Bewerterstufe zugeordneten NOR-Gatters N und wirkt deshalb im Sinne einer Prioritätenbildung, falls ein Komparator fehlerhaft arbeitet und einen Offset-Fehler von zwei Stufen aufweist. Ohne diese Prioritätenbildung würden dann zwei NOR-Gatter an ihren Ausgängen auf logisch «1» gehen. Die NOR-Gatter N bilden aus dem «x-aus n-Code» der Komparatoren K einen «1-aus-n-Code».

Über die Transfertransistoren T gelangt das «1-aus-n-Code»-Signal in einen Festwert-Speicher ROM, der dieses Signal in einen Dual-Code umwandelt. Die Signalausgänge des Festwertspeichers ROM sind über je einen Transfertransistor t an den Eingang je eines Verstärkers AU gelegt, deren Ausgänge in ihrer Gesamtheit das dem angelegten Analogsignal E entsprechende duale Digitalsignal liefern. Zur Steuerung der Transfertransistoren t dient dasjenige der beiden Taktsignale $\emptyset_1$ und $\emptyset_2$, das gemäss der Definition der Erfindung zur Steuerung des vierten Transfertransistors T4 in den vorgesehenen Komparatoren K vorgesehen ist, d.h. also das Taktsignal $\emptyset1$. Das andere Taktsignal $\emptyset_2$ geht an den Eingang eines den Verstärkern AU entsprechenden Verstärkers AT. Das am Ausgang dieses Verstärkers AT erscheinende Signal bildet den Takt bei der Bewertung des an der Gesamtheit der Ausgangsverstärker AU gelieferten digitalen Ausgangssignals des Wandlers.

Die Trennung des Signaldurchlaufs durch zeitlich versetzt getaktete Transfertransistoren T und t ermöglicht den Gattern eine längere Schaltzeit bei gleichem Informationsdurchsatz gegenüber einer Schaltung mit direktem Signaldurchlauf. Ausserdem wird die Ausgabe der Signale auch bei unterschiedlicher Gatterlaufzeit synchronisiert.

Die Transfertransistoren T und t entsprechen zweckmässig bezüglich ihrer Ausgestaltung den Transfertransistoren in den vorgesehenen Komparatoren K.

**Patentansprüche**

1. Monolithisch integrierbare MOS-Komparatorschaltung für den Vergleich einer an den Signaleingang (SE) des Komparators zu legenden Signalspannung mit der an den Referenzeingang (RE) des Komparators zu legenden Referenzspannung, bei der wenigstens zwei hintereinander geschaltete und bezüglich der Versorgungsspannung parallel geschaltete Verstärkerstufen vorgesehen sind, wobei der Signaleingang (SE) und der Referenzeingang (RE) des Komparators über je einen taktgesteuerten Transfertransistor (T1, T2) wechselweise an denselben Pol eines Kondensators (C) gelegt ist, dessen zweiter Pol unmittelbar mit dem Steuereingang einer ersten als Inverter ausgestalteten Verstärkerstufe (I1) verbunden ist, dadurch gekennzeichnet, dass der zweite Pol über einen weiteren Transfertransistor (T3) mit dem Ausgang dieses ersten Inverters (I1) verbunden ist, dass ferner der Ausgang dieses ersten Inverters (I1) über einen vierten Transfertransistor (T4) an den Steuereingang einer ebenfalls als Inverter ausgestalteten zweiten Verstärkerstufe (I2) gelegt und der Ausgang dieses zweiten Inverters (I2) einerseits als ein Signalausgang (Q̄) des Komparators verwendet und andererseits an den Signaleingang eines dritten und mit dem ersten sowie mit dem zweiten Inverter übereinstimmenden Inverters (I3) gelegt ist, dessen Signalausgang sowohl als ein zweiter Signalausgang (Q) des Komparators verwendet als auch über einen fünften Transfertransistor (T5) mit dem Steuereingang des zweiten Inverters (I2) verbunden ist, und dass schliesslich die beiden den Signaleingang (SE) bzw. den Referenzeingang (RE) des Komparators an den besagten Kondensator (C) schaltenden Taktsignale (∅₁, ∅₂) so aufeinander abgestimmt sind, dass je ein Impuls des einen Taktsignals in die Pause zwischen zwei aufeinanderfolgenden Impulsen des anderen Taktsignals fällt und beide Taktsignale (∅₁, ∅₂) zur Steuerung der übrigen Transfertransistoren (T3–T5) derart verwendet sind, dass sowohl die Verbindung zwischen dem Kondensator (C) und dem Ausgang des ersten Inverters (I1) als auch die Verbindung zwischen dem Eingang des zweiten Inverters (I2) und dem Ausgang des dritten Inverters (I3) von dem einen Taktsignal (∅₂) und die Verbindung zwischen dem Ausgang des ersten Inverters (I1) zum Signaleingang des zweiten Inverters (I2) von dem anderen Taktsignal (∅₁) gesteuert ist (Fig. 1).

2. Anordnung nach Anspruch 1, dadurch gekennzeichnet, dass das die Verbindung des Signaleingangs (SE) steuernde Taktsignal (∅₁) zur Steuerung des die Verbindung zwischen dem Ausgang des ersten Inverters (I1) und dem Signaleingang des zweiten Inverters (I2) bildenden vierten Transfertransistors (T4) vorgesehen ist.

3. Anordnung nach Anspruch 1 oder 2, dadurch gekennzeichnet, dass der Komparator in Ein-Kanal-MOS-Technik, insbesondere in n-Kanal-MOS-Technik, realisiert ist.

4. Integrierte Halbleiterschaltung für einen Analog-Digital-Wandler nach dem Parallelverfahren mit einer Anzahl n einander gleicher Komparatoren nach einem der Ansprüche 1 bis 3, dadurch gekennzeichnet, dass die an ihren Referenzeingängen (RE) in gestaffelter Weise an je eine Referenzspannung und an ihren Signaleingängen (SE) gemeinsam durch ein auszuwertendes Signal (E) beaufschlagten Komparatoren (K) mit ihrem durch den dritten Inverter (I3) gegebenen Signalausgang (Q) an den einen Eingang je eines zusammen mit dem Inverter (I3) je eine Bewerterstufe bildenden NOR-Gatters sowie ausserdem an einen weiteren Eingang des entsprechenden NOR-Gatters gelegt ist, das dem durch die nächst höhere Referenzspannung beaufschlagten Komparator (K) zugeteilt ist, dass weiterhin ein dritter Eingang dieser NOR-Gatter (N) für die Steuerung durch den zweiten Inverter (I2) des durch die jeweils nächst niedrigere Referenzspannung beaufschlagten Komparators gegebenen Ausgang (Q̄) desselben vorgesehen ist und dass schliesslich die einzelnen Ausgänge dieser NOR-Gatter (N) über je einen Transfertransistor (T) mit je einem Eingang eines Festwertspeichers (ROM) verbunden und dabei die Gesamtheit dieser Transfertransistoren durch dasjenige der beiden Taktsignale für die Komparatoren (K) gesteuert ist, das zur Steuerung des dritten Transfertransistors (T3) dieser Komparatoren (K) dient (Fig. 2).

5. Anordnung nach Anspruch 4, dadurch gekennzeichnet, dass das der Steuerung der vierten Transfertransistoren (T4) der vorgesehenen Komparatoren (K) dienende gemeinsame Taktsignal (∅₁) zur Steuerung weiterer Transfertransistoren (t) vorgesehen ist, von denen sich jeweils ein Transfertransistor zwischen je einem der Signalausgänge des Festwertspeichers (ROM) und einem diesem Ausgang zugeordneten Ausgangsverstärker (AU) befindet, und dass zur Bewertung der an den Ausgängen dieser Verstärker (AU) erscheinenden Digitalsignale das über einen weiteren Verstärker (AT) geführte andere Taktsignal (∅₂) verwendet ist (Fig. 2).

**Claims**

1. A monolithic integrated MOS-comparator circuit for the comparison of a signal voltage to be connected to the signal input (SE) of the comparator with the reference voltage to be connected to the reference input (RE) of the comparator, wherein are arranged at least two consecutively switched amplifier stages switched in parallel in respect of the supply voltage, wherein the signal input (SE) and the reference input (RE) of the comparator are alternately connected via a pulse-controlled transfer transistor (T1, T2) to the same pole of a capacitor (C), whose second pole is directly connected to the control input of a first amplifier stage (I1) designed as an inverter, characterised in that the second pole is connected to the output of the first inverter (I1) by a further transfer transistor (T3), that furthermore the output of the first inverter (I1) is connected via a fourth transfer transistor (T4) to the control input of a second amplifier stage (I2) in the form of an inverter, and the output of the second inverter (I2) is used as a signal output (Q̄) of the comparator on the one hand, and is connected on the other hand to the signal input of a third inverter (I3) which corresponds to the first and second inverters and whose signal output is used as a second signal output (Q̄) of the comparator and connected to the control input of the second inverter (I2) by means of a fifth transfer transistor (T5), and that the two clock pulse signals (∅₁, ∅₂), which connect the signal input (SE) and the reference input (RE) of the comparator to said capacitor (C), are finally matched to one another in such a manner that a pulse of the one clock pulse signal falls into the pause between two consecutive pulses of the other clock pulse signal and both clock pulse signals ($\varnothing_1$, $\varnothing_2$) are used for the control of the remaining transfer transistors (T3–T5) in such a manner that both the connection between the capacitor (C) and the output of the first inverter (I1) and also the connection between the input of the second inverter (I2) and the output of the third inverter (I3) is controlled by the one clock pulse signal ($\varnothing_2$) and the connection between the output of the first inverter (I1) to the signal input of the second inverter (I2) is controlled by the other clock pulse signal ($\varnothing_1$), (Fig. 1).

2. An arrangement as claimed in Claim 1, characterised in that the clock pulse signal ($\varnothing_1$) controlling the connection of the signal input (SE) is provided to control the fourth transfer transistor (T4) which forms the connection between the output of the first inverter (I1) and the signal input of the second inverter (I2).

3. An arrangement as claimed in Claim 1 or 2, characterised in that the comparator is formed by single-channel MOS technology, in particular n-channel MOS technology.

4. An integrated semiconductor circuit for an analogue-digital converter operating in accordance with the parallel process, with a number n of identical comparators as claimed in one of Claims 1 to 3, characterised in that the comparators (K), which at their reference inputs (RE) are respectively connected to a reference voltage in staggered fashion and commonly acted upon at their signal inputs (SE) by a signal (E) to be analysed, have their signal outputs (Q), represented by the third inverter (I3), respectively connected to the one input of a NOR-gate which together with the inverter (I3) respectively forms an analysing stage, and are furthermore connected to a further input of the corresponding NOR-gate assigned to the comparator (K) acted upon by the next higher reference voltage, that furthermore a third input of the NOR-gate (N) is provided for control by the second inverter (I2) of the output ($\overline{Q}$) represented by the comparator acted upon by the respectively next lower reference voltage, and that the individual outputs of the NOR-gates (N) are finally connected to an input of a read-only memory (ROM) by means of a respective transfer transistor (T), and all the transfer transistors are controlled by the two clock pulse signals for the comparators (K) which serves to control the third transfer transistor (T3) of the comparators (K), (Fig. 2).

5. An arrangement as claimed in Claim 4, characterised in that the common clock pulse signal ($\varnothing_1$), which serves to control the fourth transfer transistors (T4) of the comparators (K), is utilised for control of further transfer transistors (t), one of which transfer transistors is respectively arranged between one of the signal outputs of the read-only memory (ROM) and an output amplifier (AU) assigned to this output, and that the other clock pulse signal ($\varnothing_2$) supplied via a further amplifier (AT) is used for analysing the digital signals which occur at the outputs of the amplifiers (AU), (Fig. 2).

## Revendications

1. Circuit comparateur MOS susceptible d'intégration monolithique pour la comparaison d'une tension de signal, devant être appliquée à l'entrée des signaux (SE) du comparateur, à la tension de référence devant être appliquée à l'entrée de référence (RE) du comparateur et dans lequel il est prévu au moins deux étages amplificateurs, qui sont branchés en série l'un avec l'autre et sont branchés en parallèle par rapport à la tension d'alilimentation, l'entrée des signaux (SE) et l'entrée de référence (RE) du comparateur étant raccordées en alternance, par l'intermédiaire de transistors respectifs de transfert (T1, T2) commandés de façon cadencée, à la même borne d'un condensateur (C), dont la seconde borne est reliée directement à l'entrée de commande d'un premier étage amplificateur (I1) réalisé sous la forme d'un inverseur, caractérisé par le fait que la seconde borne est reliée par l'intermédiaire d'un autre transistor de transfert (T3) à la sortie de ce premier inverseur (I1), qu'en outre la sortie de ce premier inverseur (I1) est raccordée par l'intermédiaire d'un quatrième transistor de transfert (T4) à l'entrée de commande d'un second étage amplificateur (I2) réalisé également sous la forme d'un inverseur et que la sortie de ce second inverseur (I2) est d'une par utilisée en tant que sortie des signaux ($\overline{Q}$) du comparateur et est d'autre part raccordée à l'entrée des signaux d'un troisième inverseur (I3), identique au premier ainsi qu'au second inverseur et dont la sortie des signaux est utilisée en tant que seconde sortie des signaux (Q) du comparateur tout en étant reliée par l'intermédiaire d'un cinquième transistor de transfert (T5) à l'entrée de commande du second inverseur (I2), et qu'enfin les deux signaux de cadence ($\varnothing_1$, $\varnothing_2$) raccordant l'entrée des signaux (SE) ou l'entrée de référence (RE) du comparateur audit condensateur (C), sont accordés entre eux de telle sorte que respectivement une impulsion d'un signal de cadence intervient pendant la pause entre deux impulsions successives de l'autre signal de cadence et que les deux signaux de cadence ($\varnothing_1$, $\varnothing_2$) sont utilisés pour commander les autres transistors de transfert (T3–T5) de telle sorte qu'aussi bien la liaison entre le condensateur (C) et la sortie du premier inverseur (I1) ainsi que la liaison entre l'entrée du second inverseur (I2) et la sortie du troisième inverseur (I3) sont commandées par un signal de cadence ($\varnothing_2$) et que la liaison entre la sortie du premier inverseur (I1) et l'entrée des signaux du second inverseur (I2) est commandée par un autre signal de cadence ($\varnothing_1$) (figure 1).

2. Dispositif suivant la revendication 1, caractérisé par le fait que le signal de cadence ($\varnothing_1$) commandant la liaison avec l'entrée des signaux (SE) est prévu pour réaliser la commande du quatrième transistor de transfert (T4) établissant la liaison entre la sortie du premier inverseur (I1) et l'entrée des signaux du second inverseur (I2).

3. Dispositif suivant la revendication 1 ou 2, caractérisé par le fait que le comparateur est réalisé selon la technique MOS à un canal, notamment selon la technique MOS à canal n.

4. Circuit intégré à semiconducteurs pour un convertisseur analogique/numérique fonctionnant selon le procédé en parallèle avec un nombre n de comparateurs identiques entre eux, conformément à l'une des revendications 1 à 3, caractérisé par le fait que les comparateurs (K), qui sont chargés de façon étagée, au niveau de leurs entrées de référence (RE), par une tension de référence respective et en commun, au niveau de leurs entrées et des signaux (SE), par un signal (E) devant être exploité, sont raccordés par leur sortie des signaux (Q), formée par le troisième inverseur (I3), à une entrée d'une porte NON-OU, formant respectivement un étage de pondération avec l'inverseur (I3), et en outre à une autre entrée de la porte NON-OU correspondante, qui est raccordée au comparateur (K) chargé par la tension de référence immédiatement supérieure, qu'en outre une troisième entrée de ces portes NON-OU (N) est prévue pour la commande, réali-

sée par la sortie ($\overline{Q}$) formée par le second inverseur (I2) du comparateur chargé par la tension de référence immédiatement inférieure, de ce comparateur et qu'enfin les différentes sorties de ces portes NON-OU (N) sont reliées par l'intermédiaire de transistors respectifs de transfert (T) à des entrées respectives d'une mémoire morte (ROM) et que l'ensemble de ces transistors de transfert sont commandés par celui des deux signaux de cadence prévus pour les comparateurs (K), qui est utilisé pour la commande du troisième transistor de transfert (T3) de ces comparateurs (K) (figure 2).

5. Dispositif suivant la revendication 4, caractérisé par le fait que le signal de cadence commun ($\varnothing_1$), qui sert à réaliser la commande des quatrièmes transistors de transfert (T4) est prévu pour réaliser la commande d'autres transistors de transfert (a), parmi lesquels un transistor de transfert respectif est situé entre respectivement l'une des sorties des signaux de la mémoire morte (ROM) et un amplificateur de sortie (AU) associé à cette sortie, et que pour réaliser la pondération des signaux numériques apparaissant au niveau de sorties de ces amplificateurs (AU), on utilise l'autre signal de cadence ($\varnothing_2$) délivré par l'intermédiaire d'un autre amplificateur (AT) (figure 2).

0 071 265

# FIG 1

# FIG 1a